# EUROPÄISCHE PATENTSCHRIFT

(11) **EP 2 495 855 B1**
(45) Veröffentlichungstag und Bekanntmachung des Hinweises auf die Patenterteilung: **01.05.2019**
(21) Anmeldenummer: 12150618.2
(22) Anmeldetag: 10.01.2012
(51) Int. Cl.: H02H 7/125, H02H 9/04, H02M 1/00, H02M 1/32, H02M 7/06, H02M 7/12, H02M 7/217, H03K 17/0814, H03K 17/082, H03K 17/30, H02H 7/06, H02J 7/24, H02P 9/00, H02P 9/10

(54) **Verfahren zur Verlustleistungsreduktion bei der Spannungsklammerung von aktiven Gleichrichterschaltungen**
Method for power loss reduction in the voltage bracketing of active rectifier circuits
Procédé de réduction de la perte de puissance lors du verrouillage de la tension de circuits redresseurs actifs

(30) Priorität: 22.02.2011 DE 102011004484
(43) Veröffentlichungstag der Anmeldung: 05.09.2012
(73) Patentinhaber: Robert Bosch GmbH, 70442 Stuttgart (DE); SEG Automotive Germany GmbH, 70499 Stuttgart (DE)
(72) Erfinder: Mehringer, Paul, 70569 Stuttgart (DE); Baur, Markus, 72108 Rottenburg (DE)

(56) Entgegenhaltungen:
- DE-A1-102007 060 219

## Beschreibung

Die Erfindung betrifft ein Verfahren zur Spannungsklammerung bei einer eine Gleichrichterschaltung aufweisenden Generatorvorrichtung zum Zwecke einer Reduktion der Verlustleistung.

### Stand der Technik

Zur Speisung von Gleichstromsystemen aus Drehstromsystemen, beispielsweise dem öffentlichen Drehstromnetz, werden im Allgemeinen Gleichrichter verwendet. Diese Gleichrichter sind meist als Brückenschaltung aufgebaut. Als Gleichrichterelemente dienen Dioden. Derartige Dioden benötigen keine Ansteuerschaltung, da sie selbständig zum richtigen Zeitpunkt in den leitenden bzw. sperrenden Zustand übergehen.

Brückengleichrichter werden auch als Gleichrichter in Kraftfahrzeuggeneratoren verwendet.

Ein Gleichrichter hat eine durch die Dioden und den Ausgangsstrom vorgegebene Verlustleistung. Durch schaltungstechnische Maßnahmen, beispielsweise durch ein Parallelschalten von Dioden, lassen sich diese Verluste nur unwesentlich verkleinern.

Eine wesentliche Verkleinerung dieser Verluste kann dadurch erreicht werden, dass die genannten Dioden durch aktive Schalter, beispielsweise durch MOSFETs ersetzt werden. Derartige aktive Schalter benötigen jedoch eine Steuerung, die die Schalter zum jeweils richtigen Zeitpunkt ein- bzw. ausschaltet.

Ein kritischer Betriebszustand eines aktiven Gleichrichters ist das Auftreten eines Lastabwurfs (Load Dump). Ein maximaler Lastabwurf liegt vor, wenn bei erregter Maschine mit maximalem abgegebenem Strom das Lastkabel abfällt oder schlagartig alle Verbraucher abgeschaltet werden. In einem derartigen Fall liefert der Generator für einen Zeitraum, der typischerweise im Bereich von 300 ms bis 500 ms liegt, weiterhin Energie. Diese Energie muss im Gleichrichter umgesetzt werden, um das Bordnetz vor einer Schädigung durch eine Überspannung zu schützen.

Im Falle einer Verwendung von herkömmlichen Diodengleichrichtern kann diese Verlustenergie in Wärme umgesetzt werden. Diodengleichrichter bieten eine ausreichend gute Aufbau- und Verbindungstechnik mit sehr niedrigen thermischen Impedanzen.

Im Falle der Verwendung von MOSFETs als Schalter ist die Umsetzung der Verlustenergie in Wärme aufgrund vergleichweise hoher thermischer Impedanzen der Aufbau- und Verbindungstechnik und aufgrund des Verhaltens der MOSFETs nur eingeschränkt möglich. MOSFETs halten im Spannungsklammerungsbetrieb im Vergleich zu Dioden geringeren Belastungen Stand.

Aus der DE 10 2007 060 219 A1 sind Gleichrichterschaltungen bekannt, welche anstelle von Dioden zur Gleichrichtung von Wechselspannungen verwendbar sind und welche ebenso wie Dioden zwei Pole mit einem Kathodenanschluss und einem Anodenanschluss bilden. Die Verlustleistung derartiger Gleichrichterschaltungen ist deutlich geringer als die Verlustleistung von Silizium-pn-Dioden. Eine der in der DE 10 2007 060 219 A1 beschriebenen Gleichrichterschaltungen enthält einen Kathodenanschluss, einen Anodenanschluss und eine zwischen dem Kathodenanschluss und dem Anodenanschluss vorgesehene elektronische Schaltung, welche einen MOS-Transistor mit integrierter Inversdiode, einen Kondensator, einen Differenzverstärker und einen Begrenzer, der die Potentialdifferenz zwischen dem Kathodenanschluss und dem Anodenanschluss auf einen vorgegebenen Wert begrenzt. Eine derartige Begrenzung der Potentialdifferenz stellt eine Spannungsklammerung dar und bildet in speziellen Fällen einen Loaddump-Schutz.

Aus der DE 100 01 876 C1 ist ein Leistungstransistor bekannt, der eine Überspannungs-Schutzschaltung zur Vermeidung eines Avalanche-Betriebszustands aufweist. Dieser Leistungstransistor enthält mindestens ein Steuergate zum Steuern eines zugehörigen Hauptstromkanals zwischen einem Drainanschluss und einem Sourceanschluss eines Haupttransistors, mindestens ein Zusatzgate zum Steuern eines zugehörigen Nebenstromkanals zwischen einem Drainanschluss und einem Sourceanschluss eines Nebentransistors und eine Schutz-Zenerdiode, über welche das Zusatzgate an die Drainanschlüsse angeschlossen ist.

Aus der EP 0 777 309 B1 ist es bekannt, zur Löschung der Loaddump-Energie einen Highside- oder Lowside-Zweig einer Gleichrichterbrücke komplett kurzzuschließen. Nachteilig bei dieser Lösung ist, dass im Falle einer nicht vorhandenen Batterie wegen eines Defektes oder eines Kabelabfalls die Spannungsversorgung schlagartig einbricht. In diesem Falle treten systemkritische Zustände ein, da auch der Gleichrichter seine Energie aus dem Bordnetz bezieht. Des Weiteren ist diese Lösung nicht mit herkömmlichen Bordnetzreglern kombinierbar, da diese nach dem Erkennen einer Unterspannung den Erregerstrom hochregeln. Dies hat zur Folge, dass ein Loaddump-Zustand nicht beendet werden kann.

### Offenbarung der Erfindung

Ein Verfahren mit den im Anspruch 1 angegebenen Merkmalen weist demgegenüber mehrere Vorteile auf. Ein Vorteil besteht darin, dass sichergestellt ist, dass beim Auftreten eines Lastabwurfs die Verlustleistung in den Endstufen minimiert und dennoch ein ausreichender Abstand zu kritischen Spannungsbereichen eingehalten wird. Des Weiteren ist es nicht notwendig, eine spezielle Auswerteeinheit zu verwenden, die die erwartete Dauer des Lastabwurfs abschätzt und für diese geschätzte Dauer Gegenmaßnahmen einleitet. Beim erfindungsgemäßen Verfahren wird für jede positive Halbwelle einer zwischen dem Kathodenanschluss und dem Anodenanschluss anliegenden Wechselspannung ermittelt, ob die Potentialdifferenz zwischen dem Kathodenanschluss und dem Anodenanschluss größer ist als ein vorgegebener, für das Vorliegen eines Lastabwurfs vorgegebener Schwellenwert, und - wenn dies der Fall ist - die Potentialdifferenz zwischen dem Kathodenanschluss und dem Anodenanschluss bis zum Ende der vorliegenden Halbwelle auf einen vorgegebenen Spannungswert begrenzt, der kleiner ist als der vorgegebene Schwellenwert des Lastabwurfs.

Die Dauer, in der Überspannungen aufgrund eines Lastabwurfs auftreten, kann sich beispielsweise über einen Zeitraum hinziehen, der im Bereich zwischen 300 ms und 500 ms liegt. Innerhalb dieses Zeitraums liegt zwischen dem Kathodenanschluss und dem Anodenanschluss der Gleichrichterschaltung eine Wechselspannung an, die eine Vielzahl von positiven Halbwellen aufweist. Die Dauer dieser Halbwellen ist abhängig von der aktuellen Drehzahl und der Polpaarzahl des Generators. Bei einer Drehzahl von beispielsweise 6000 U/min und einer Polpaarzahl von 8 beträgt die Dauer einer Halbwelle 625 µs. Bei der vorliegenden Erfindung wird für jede positive Halbwelle neu ermittelt, ob die Potentialdifferenz zwischen dem Kathodenanschluss und dem Anodenanschluss des Gleichrichterelements größer ist als ein vorgegebener, für das Vorliegen eines Lastabwurfs charakteristischer Schwellenwert, und - wenn dies der Fall ist - erfolgt eine Begrenzung dieser Potentialdifferenz bis zum Ende der vorliegenden Halbwelle auf einen vorgegebenen Spannungswert, der kleiner ist als der vorgegebene Schwellenwert. Beispielsweise beträgt der vorgegebene Schwellenwert 25 V und der vorgegebene Spannungswert 16 V.

Nachfolgend wird die vorliegende Erfindung anhand der Zeichnung näher erläutert. Es zeigt
- Figur 1: ein Diagramm zur Veranschaulichung der Leistungsabgabe beim Vorliegen eines Lastabwurfs,
- Figur 2: ein Diagramm zur Veranschaulichung des gemessenen Abgabestroms beim Vorliegen eines Lastabwurfs,
- Figur 3: eine schematische Darstellung eines Ausführungsbeispiels für eine Generatorvorrichtung,
- Figur 4: ein Diagramm zur Veranschaulichung des Zusammenhangs zwischen der Spitzenverlustleistung und der Klammerspannung,
- Figur 5: ein Ausführungsbeispiel für eine Gleichrichterschaltung gemäß der Erfindung,
- Figur 6: Skizzen zur Veranschaulichung des Verlaufs der Phasenspannung und der Bordnetzspannung,
- Figur 7: weitere Skizzen zur Veranschaulichung des Verlaufs der Phasenspannung und der Bordnetzspannung.

Bei einem Lastabwurf tritt ausgehend von der geregelten Ausgangsspannung ein sehr schneller Spannungsanstieg auf, da der Generator über seine Phasenanschlüsse zwangsläufig noch elektrische Leistung abgibt, solange der Stromfluss in der Erregerwicklung nicht abgebaut ist.

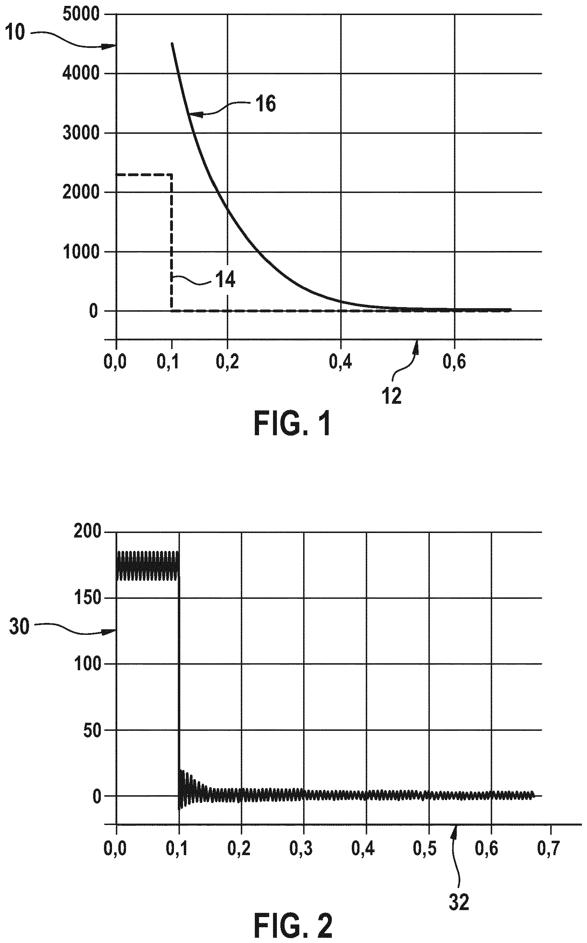

Da im Extremfall die Stromabgabe in das Bordnetz unterbrochen ist oder durch Abschalten der Verbraucher einen Sollwert von ,0' besitzt, muss diese Leistung im Gleichrichter umgesetzt werden. Aufgrund des Spannungsanstiegs und der Stromabgabe über die Phasen des Generators steigt die abgegebene Leistung des Generators steil an. Ein Beispiel für eine gemessene Leistungsabgabe ist in der Figur 1 dargestellt.

Dabei ist in der Figur 1 der Verlauf der Leistung vor und nach einem Lastabwurf beispielhaft gezeigt. Dabei ist insbesondere die gemessene Leistungsabgabe eines Ständers einer elektrischen Maschine beim Lastabwurf dargestellt. An der Ordinate 10 ist dabei die Leistung P in Watt und an der Abszisse 12 die Zeit t in Sekunden aufgetragen. Der Lastabwurf findet zum Zeitpunkt t = 0,1 s statt.

Eine Kurve 14 zeigt die Leistung, die der Generator an das Bordnetz abgibt. Eine weitere Kurve 16 zeigt die Leistung, die der Gleichrichter während des Lastabwurfs aufnehmen muss. Das Lastabwurf- Ereignis beginnt bei 0,1 s. Die Kurve 16 folgt näherungsweise einer e-Funktion mit einer Zeitkonstanten T, die durch den Erregerkreis des Generators bestimmt ist.

In der Figur 2 ist eine gemessene Stromkurve bei einem Lastabwurf dargestellt. Das Diagramm zeigt ein Beispiel eines gemessenen Abgabestroms hinter dem Gleichrichter bei einem Lastabwurf. An der Ordinate 30 ist dabei der Strom in Ampere und an der Abszisse 32 die Zeit in Sekunden aufgetragen.

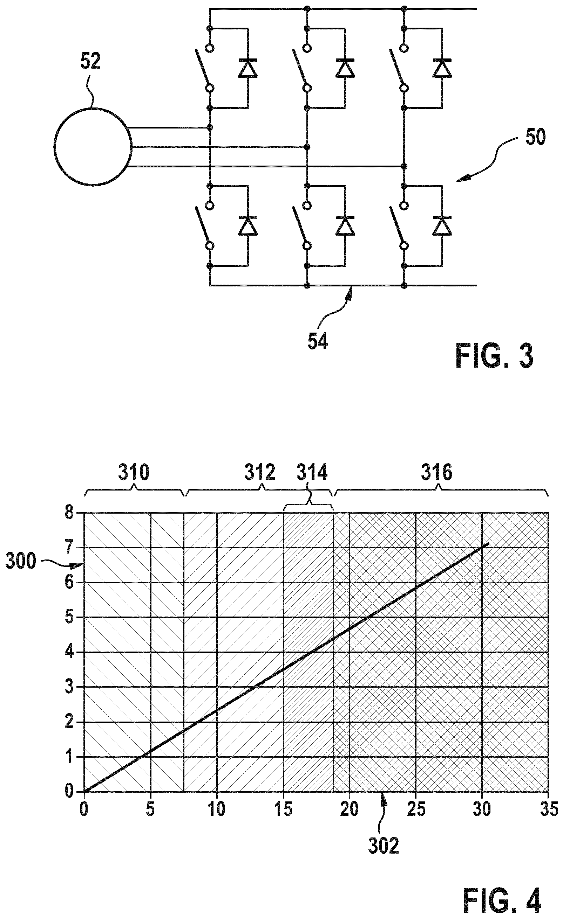

In der Figur 3 ist in einer schematischen Darstellung eine Ausführung einer Generatorvorrichtung gezeigt, die insgesamt mit der Bezugsziffer 50 bezeichnet ist. In der Darstellung sind ein Generator 52 und ein Gleichrichter 54, der als Brückengleichrichter aufgebaut ist, gezeigt.

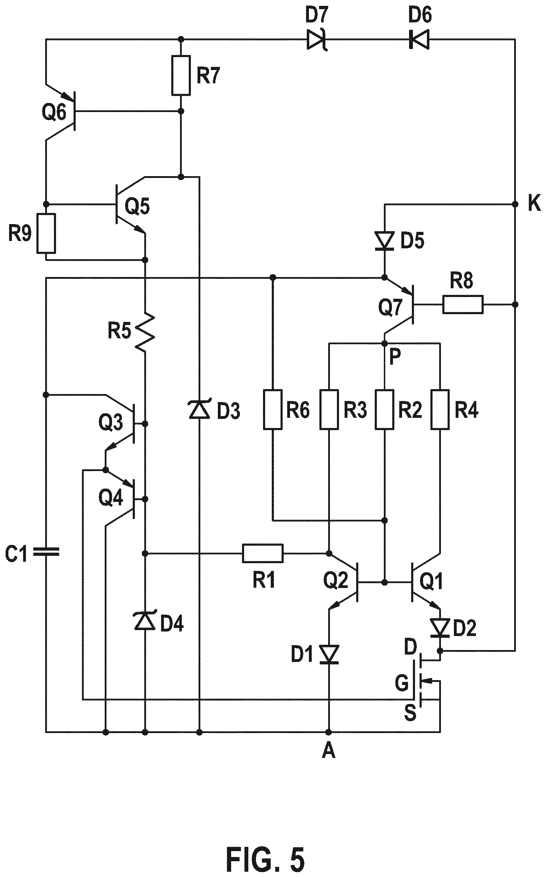

Gemäß der vorliegenden Erfindung wird jeder der Schalter des Brückengleichrichters durch eine Gleichrichterschaltung ersetzt. Ein Beispiel für eine derartige Gleichrichterschaltung wird unten anhand der Figur 5 erläutert.

Die im Gleichrichter als Folge des Lastabfalls umgesetzte Leistung nimmt mit der Klammerspannung des Gleichrichters nahezu proportional zu. Ziel ist es, im Sinne einer Verlustleistungsoptimierung die Klammerspannung so niedrig wie möglich zu halten.

In der Figur 4 ist der Zusammenhang zwischen der Spitzenverlustleistung und der Klammerspannung bei 230 A Ausgangsstrom dargestellt. Dabei ist in dieser Darstellung an der Ordinate 300 die Verlustleistung in Kilowatt und an der Abszisse 302 die Klammerspannung in Volt aufgetragen. Die Figur 4 zeigt unterschiedliche Spannungsbereiche, die durch folgende Merkmale gekennzeichnet sind:

| | |
|---|---|
| erster Bereich 310: | Klammerspannung < 8 V; die Spannungsversorgung im Bordnetz bricht ein |
| zweiter Bereich 312: | 8 V < Klammerspannung < 18 V; normaler Betriebsbereich |
| dritter Bereich 314: | 15 V < Klammerspannung < 18 V; normaler Betriebsbereich oberhalb der Regelspannung des Spannungsreglers |
| vierter Bereich 316: | Klammerspannung > 18 V; oberhalb des normalen Betriebsbereichs mit hoher Verlustleistung. |

Die Klammerung von bekannten Diodengleichrichtern arbeitet im Spannungsbereich oberhalb von 18 V. Damit ist gewährleistet, dass die Spannungsklammerung nur außerhalb des normalen Betriebsmodus stattfindet.

Da aktive Gleichrichter hinsichtlich Zeit und Klammerspannung gesteuert arbeiten können, kann die Klammerspannung herabgesetzt werden, um die Verlustleistung zu reduzieren. Hierbei ist der dritte Bereich 314 zwischen 15 V und 18 V bevorzugt einzusetzen, da in diesem Spannungsbereich der Regler abregelt, alle elektronischen Geräte weiter stabil arbeiten und die Verlustleistung deutlich geringer als im vierten Bereich 316 mit mehr als 18 V ist. Bei einer Spannungsklammerung unterhalb von 15 V von Seiten des Gleichrichters würde jedoch ohne Zusatzmaßnahmen am Regler der Fall eintreten, dass die Spannungsklammerung des Gleichrichters gegen die Spannungsregelung des Reglers arbeitet und der Load Dump-Zustand nicht verlassen werden kann. Damit bietet der Spannungsbereich zwischen 15 V und 18 V den günstigsten Kompromiss zwischen Verlustleistung und unveränderter Regelung. Im Fall einer überlagerten Logik, die den aktuellen Lastabfall erkennt und dem Regler einen niedrigeren Sollspannungswert vorgibt, ist auch eine Regelung auf z.B. 8 V denkbar. Eine aktiv ansteuerbare Spannungsklammerung, die einen Lastabwurf am Überschreiten eines hohen Spannungsniveaus von beispielsweise 25 V erkennt und nach dem Erkennen des Lastabwurfs die Spannungsklammerung auf ein niedrigeres Niveau von beispielsweise 16 V reduziert, ist Gegenstand der vorliegenden Erfindung.

Die Figur 5 zeigt ein Ausführungsbeispiel für eine Gleichrichterschaltung gemäß der Erfindung, die eine derartige Spannungsklammerung aufweist.

Die in der Figur 5 dargestellte Gleichrichterschaltung kann anstelle jedes der in der Figur 3 gezeigten Schalter der Gleichrichterbrücke eingesetzt werden. Sie weist einen Kathodenanschluss K und einen Anodenanschluss A auf. Der Kathodenanschluss K ist mit dem Drainanschluss D eines MOSFETs M1 verbunden. Der Anodenanschluss A ist mit dem Sourceanschluss S des MOSFETs M1 verbunden.

Des Weiteren ist der Drainanschluss D des MOSFETs M1 mit der Kathode einer Diode D2 verbunden, deren Anode an den Emitteranschluss eines npn-Transistors Q1 angeschlossen ist. Der npn-Transistor Q1 bildet mit einem weiteren npn-Transistor Q2 einen Differenzverstärker. Die Basisanschlüsse der beiden Transistoren Q1 und Q2 sind miteinander verbunden. Der Emitteranschluss des Transistors Q2 steht über eine Diode D1 mit dem Anodenanschluss A der Gleichrichterschaltung in Verbindung.

Der Kollektor des Transistors Q1 ist über einen Widerstand R4 an einen Schaltungspunkt P angeschlossen. Die Basisanschlüsse der beiden Transistoren Q1 und Q2 stehen über einen Widerstand R2 mit dem Schaltungspunkt P in Verbindung. Der Kollektor des Transistors Q2 ist über einen Widerstand R3 mit dem Schaltungspunkt P verbunden.

Der Kathodenanschluss K der Gleichrichterschaltung ist über einen Widerstand R8 an die Basis einen pnp-Transistors Q7 und über eine Diode D5 mit dem Emitter des Transistors Q7 verbunden. Der Kollektor des Transistors Q7 ist an den Schaltungspunkt P angeschlossen. Der Emitter des Transistors Q7 steht des Weiteren über einen Widerstand R6 mit den Basisanschlüssen der beiden Transistoren Q1 und Q2, über einen Kondensator C1 mit dem Anodenanschluss A der Gleichrichterschaltung und mit dem Kollektor eines npn-Transistors Q3 in Verbindung.

Der npn-Transistor Q3 bildet zusammen mit einem pnp-Transistor Q4 eine Stromverstärkerstufe. Dabei sind die Emitter und die Basisanschlüsse dieser Transistoren jeweils miteinander verbunden. Der Kollektor des Transistors Q4 steht mit dem Anodenanschluss A in Verbindung. Die Emitter der beiden Transistoren Q3 und Q4 sind mit dem Gateanschluss G des MOSFETs M1 verbunden. Die Basisanschlüsse der beiden Transistoren Q3 und Q4 stehen über eine Zenerdiode D4 in Kontakt mit dem Anodenanschluss A.

Des Weiteren ist der Kathodenanschluss K über eine Diode D6 und eine Zenerdiode D7 mit dem Emitter eines pnp-Transistors Q6 verbunden. Dieser Emitter ist über einen Widerstand R7 mit der Basis des Transistors Q6 verbunden. Der Kollektor des Transistors Q6 ist an die Basis eines npn-Transistors Q5 angeschlossen. Die Basis des Transistors Q5 steht über einen Widerstand R9 in Kontakt mit dem Emitter des Transistors Q5, welcher über einen Widerstand R5 mit den Basisanschlüssen der Transistoren Q3 und Q4 und der Kathode der Zenerdiode D4 verbunden ist. Der Kollektor des Transistors Q5 ist mit der Basis des Transistors Q6, über den Widerstand R7 mit der Anode der Zenerdiode D7 und mit der Kathode einer weiteren Zenerdiode D3 verbunden, deren Anode mit dem Anodenanschluss A der Gleichrichterschaltung kontaktiert ist.

Der Kollektoranschluss des Transistors Q2 des Differenzverstärkers Q1, Q2 ist über einen Widerstand R1 mit den Basisanschlüssen der Transistoren Q3, Q4 verbunden, die eine Stromverstärkerstufe bilden.

Die in der Figur 5 gezeigte Gleichrichterschaltung arbeitet wie folgt: Im Falle des Auftretens eines Lastabwurfs muss zur Aktivierung eines niedrigeren Spannungsniveaus zunächst erkannt werden, ob die jeweils vorliegende Halbwelle der Phasenspannung ein Spannungsniveau erreicht, das größer ist als ein vorgegebener, für das Vorliegen eines Lastabwurfs charakteristischer Schwellenwert, der beim gezeigten Ausführungsbeispiel bei ca. 25 V liegt, im Allgemeinen aber im Bereich zwischen 20 V und 35 V liegen kann. Dieses Spannungsniveau ist im Ausführungsbeispiel durch die Durchbruchsspannungen der Zenerdioden D3 und D7 definiert. Jeder Stromfluss durch die Zenerdioden D3 und D7, der zu einer Aufsteuerung der Transistoren Q5 und Q6 führt, bewirkt für die restliche Dauer der verursachenden Halbwelle eine Reduktion der zwischen dem Kathodenanschluss K und dem Anodenanschluss A anliegenden Spannung auf einen vorgegebenen Spannungswert. Dieser liegt im Bereich zwischen 15 V und 18 V, beim vorliegenden Ausführungsbeispiel bei ca. 16 V. Dieses niedrigere Spannungsniveau ist überwiegend durch die Durchbruchsspannung der Zenerdiode D7 bestimmt.

Nach alledem wird beim gezeigten Ausführungsbeispiel zunächst das Vorliegen eines Lastabwurfs daran erkannt, dass durch die Zenerdioden D7 und D3 in deren Sperrrichtung ein Strom fließt. Dieser steuert die Transistorschaltung Q5, Q6 auf, so dass diese über den Stromverstärker Q3, Q4 das Gate G des MOSFETs M1 derart ansteuert, dass das MOSFET in den leitenden Zustand gebracht wird. Dadurch wird im Sinne einer Klammerung die Potentialdifferenz zwischen dem Kathodenanschluss K und dem Anodenanschluss A für die restliche Dauer der verursachenden Halbwelle auf den vorgegebenen Spannungswert im Bereich zwischen 15 und 18 V begrenzt, der kleiner ist als der zur Detektion des Vorliegens eines Lastabwurfs vorgegebene Schwellenwert, der im Bereich zwischen 20 und 35 V liegt.

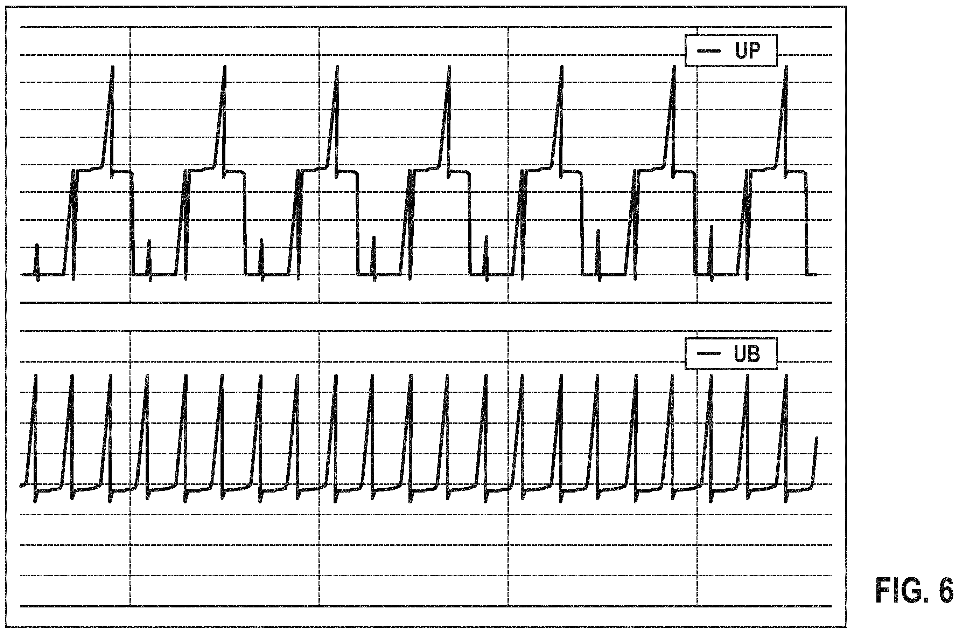

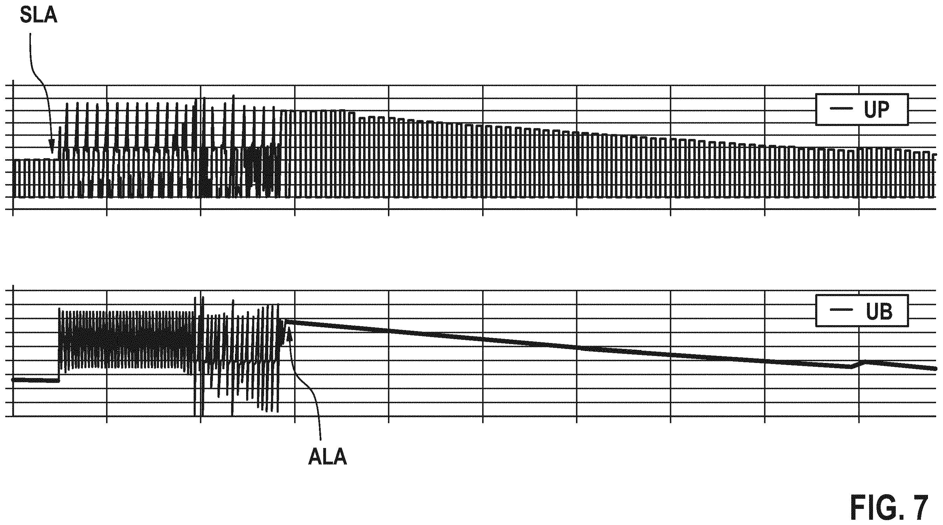

Die Figuren 6 und 7 zeigen Skizzen zur Veranschaulichung des Verlaufs der Phasenspannung und der Bordnetzspannung.

In der Figur 6 ist in der oberen Darstellung der Verlauf der Phasenspannung UP über der Zeit und in der unteren Darstellung der Verlauf der Bordnetzspannung UB über der Zeit gezeigt. Es ist ersichtlich, dass jeweils zu Beginn jeder Halbwelle charakteristische Spannungsspitzen auftreten.

In der Figur 7 ist in der oberen Darstellung der Verlauf der Phasenspannung UP über der Zeit und in der unteren Darstellung der Verlauf der Bordnetzspannung UB über der Zeit gezeigt. Es ist ersichtlich, dass sich zum Auslauf eines Lastabwurfs ein charakteristischer Anstieg der Lastabwurfs-Spannung an der Plusklemme der Batterie ergibt. Dabei ist in der Figur 7 der Beginn des Lastabwurfs mit SLA und der Beginn des Auslaufs des Lastabwurfs mit kontinuierlichem Spannungsverlauf mit ALA bezeichnet.

## Patentansprüche

1. Verfahren zur Spannungsklammerung bei einer eine Gleichrichterschaltung (54) aufweisenden Generatorvorrichtung (50), bei welchem
- zur Erkennung des Vorliegens eines Lastabwurfs für jede Halbwelle der Phasenspannung (UP) der Generatorvorrichtung (50) überprüft wird, ob diese einen vorgegebenen Schwellenwert überschreitet, **dadurch gekennzeichnet, dass**
- im Falle einer Erkennung des Vorliegens eines Lastabwurfs mittels eines Spannungsbegrenzers eine Herabsetzung der Phasenspannung (UP) auf einen vorgegebenen Spannungswert erfolgt, welcher kleiner ist als der Schwellenwert, so dass elektronische Geräte weiter stabil arbeiten und die im Gleichrichter umgesetzte Verlustleistung reduziert wird.

2. Verfahren nach Anspruch 1, **dadurch gekennzeichnet, dass** die Herabsetzung der Phasenspannung (UP) auf die vorgegebene Spannung bis zum Ende der jeweiligen Halbwelle erfolgt.

3. Verfahren nach Anspruch 1 oder 2, **dadurch gekennzeichnet, dass** der vorgegebene Schwellenwert im Bereich zwischen 20 V und 35 V liegt.

4. Verfahren nach einem der vorhergehenden Ansprüche, **dadurch gekennzeichnet, dass** der vorgegebene Spannungswert im Bereich zwischen 15 V und 18 V liegt.

5. Verfahren nach einem der Ansprüche 1 - 3, **dadurch gekennzeichnet, dass** der aktuelle Sollwert der Ausgangsspannung der Generatorvorrichtung (50) durch eine Logik am Spannungsregler auf kleiner 15 V herabgesetzt wird und der vorgegebene Spannungswert kleiner ist als 15 V.

6. Generatorvorrichtung (50) mit einer Gleichrichterschaltung (54), welche aufweist: '
- einen Detektor zur Erkennung des Vorliegens eines Lastabwurfs, der für jede Halbwelle der Phasenspannung (UP) der Generatorvorrichtung (50) überprüft, ob diese einen vorgegebenen Schwellenwert überschreitet, **gekennzeichnet durch**
- einen Spannungsbegrenzer, der im Falle einer Erkennung des Vorliegens eines Lastabwurfs eine aktive Herabsetzung der Phasenspannung (UP) auf einen vorgegebenen Spannungswert durchführt, welcher kleiner ist als der vorgegebene Schwellenwert, so dass elektronische Geräte weiter stabil arbeiten und die im Gleichrichter umgesetzte Verlustleistung reduziert wird.

7. Generatorvorrichtung nach Anspruch 6, **dadurch gekennzeichnet, dass** die Gleichrichterschaltung (54) einen Kathodenanschluss, einen Anodenanschluss und eine zwischen dem Kathodenanschluss (K) und dem Anodenanschluss (A) vorgesehene elektronische Schaltung aufweist, die eine zwischen dem Kathodenanschluss (K) und dem Anodenanschluss (A) vorgesehene Reihenschaltung zweier Zenerdioden (D7,D3) aufweist, deren Durchbruchsspannungen beim Vorliegen eines Lastabwurfs überschritten werden, so dass ein Stromfluss durch die Zenerdioden (D7,D3) erfolgt.

8. Generatorvorrichtung nach Anspruch 7, **dadurch gekennzeichnet, dass** jeder Stromfluss durch die Zenerdioden (D7,D3) eine Transistorschaltung (Q5,Q6) ansteuert, deren Ausgang mit dem Eingang eines Stromverstärkers (Q3,Q4) verbunden ist, und der Ausgang des Stromverstärkers (Q3,Q4) mit dem Gateanschluss des MOS-Transistors verbunden ist.

9. Generatorvorrichtung nach Anspruch 8, **dadurch gekennzeichnet, dass** eine erste der beiden Zenerdioden (D7) zwischen dem Kathodenanschluss (K) und dem Steueranschluss der Transistorschaltung angeordnet ist.

10. Generatorvorrichtung nach Anspruch 9, **dadurch gekennzeichnet, dass** die zweite der beiden Zenerdioden (D3) zwischen dem Steueranschluss der Transistorschaltung und dem Anodenanschluss (A) angeordnet ist.

11. Generatorvorrichtung nach Anspruch 10, **dadurch gekennzeichnet, dass** der vorgegebene Spannungswert durch die Durchbruchsspannung der ersten Zenerdiode (D7) bestimmt ist.

## Claims

1. Method for voltage clamping in a generator device (50) comprising a rectifier circuit (54), wherein
- for identifying the presence of a load dump for each half-cycle of the phase voltage (UP) of the generator device (50), a check is made to determine whether said phase voltage exceeds a predefined threshold value, **characterized in that**
- in the case of identifying the presence of a load dump, by means of a voltage limiter, the phase voltage (UP) is decreased to a predefined voltage value which is less than the threshold value, such that electronic devices continue to operate stably and the power loss converted in the rectifier is reduced.

2. Method according to Claim 1, **characterized in that** the phase voltage (UP) is reduced to the predefined voltage until the end of the respective half-cycle.

3. Method according to Claim 1 or 2, **characterized in that** the predefined threshold value lies in the range of between 20 V and 35 V.

4. Method according to any of the preceding claims, **characterized in that** the predefined voltage value lies in the range of between 15 V and 18 V.

5. Method according to any of Claims 1-3, **characterized in that** the present setpoint value of the output voltage of the generator device (50) is decreased to less than 15 V by a logic at the voltage regulator and the predefined voltage value is less than 15 V.

6. Generator device (50) having a rectifier circuit (54), which comprises:
- a detector for identifying the presence of a load dump, which detector checks for each half-cycle of the phase voltage (UP) of the generator device (50) whether said phase voltage exceeds a predefined threshold value, **characterized by**
- a voltage limiter, which, in the case of the presence of a load dump being identified, carries out an active decrease of the phase voltage (UP) to a predefined voltage value which is less than the predefined threshold value, such that electronic devices continue to operate stably and the power loss converted in the rectifier is reduced.

7. Generator device according to Claim 6, **characterized in that** the rectifier circuit (54) comprises a cathode terminal, an anode terminal and an electronic circuit provided between the cathode terminal (K) and the anode terminal (A), said electronic circuit comprising a series connection of two zener diodes (D7, D3) provided between the cathode terminal (K) and the anode terminal (A), the breakdown voltages of which zener diodes are exceeded when a load dump is present, such that a current flow through the zener diodes (D7, D3) takes place.

8. Generator device according to Claim 7, **characterized in that** each current flow through the zener diodes (D7, D3) drives a transistor circuit (Q5, Q6), the output of which is connected to the input of a current amplifier (Q3, Q4), and the output of the current amplifier (Q3, Q4) is connected to the gate terminal of the MOS transistor.

9. Generator device according to Claim 8, **characterized in that** a first of the two zener diodes (D7) is arranged between the cathode terminal (K) and the control terminal of the transistor circuit.

10. Generator device according to Claim 9, **characterized in that** the second of the two zener diodes (D3) is arranged between the control terminal of the transistor circuit and the anode terminal (A).

11. Generator device according to Claim 10, **characterized in that** the predefined voltage value is determined by the breakdown voltage of the first zener diode (D7).

## Revendications

1. Procédé de fixation de tension sur un dispositif générateur (50) comprenant un circuit redresseur (54), lors duquel
- afin de reconnaître la présence d'une variation de charge soudaine pour chaque alternance de la tension de phase (UP) du dispositif générateur (50), il est vérifié si celle-ci dépasse une valeur seuil prédéfinie, **caractérisé en ce que**
- au cas où la présence d'une variation de charge soudaine est reconnue, une réduction de la tension de phase (UP) est effectuée au moyen d'un limiteur de tension jusqu'à une valeur de tension prédéfinie, celle-ci étant inférieure à la valeur seuil, de sorte que les appareils électroniques fonctionnent de manière plus stable et que la dissipation de puissance convertie dans le redresseur soit réduite.

2. Procédé selon la revendication 1, **caractérisé en ce que** la réduction de la tension de phase (UP) à la tension prédéfinie s'effectue jusqu'à la fin de l'alternance respective.

3. Procédé selon la revendication 1 ou 2, **caractérisé en ce que** la valeur seuil prédéfinie est située dans un intervalle compris entre 20 V et 35 V.

4. Procédé selon l'une des revendications précédentes, **caractérisé en ce que** la valeur de tension prédéfinie est située dans un intervalle compris entre 15 V et 18 V.

5. Procédé selon l'une des revendications 1-3, **caractérisé en ce que** la valeur de consigne actuelle de la tension de sortie du dispositif générateur (50) est réduite à moins de 15 V au moyen d'une logique sur le régulateur de tension et la valeur de tension prédéfinie est inférieure à 15 V.

6. Dispositif générateur (50) doté d'un circuit redresseur (54), lequel comporte :
- un capteur pour reconnaître la présence d'une variation de charge soudaine, vérifiant pour chaque alternance de la tension de phase (UP) du dispositif générateur (50) si celle-ci dépasse une valeur seuil prédéfinie, **caractérisé par**
- un limiteur de tension qui, au cas où la présence d'une variation de charge soudaine est reconnue, effectue une réduction de la tension de phase (UP) à une valeur de tension prédéfinie, celle-ci étant inférieure à la valeur seuil prédéfinie, de sorte que les appareils électroniques fonctionnent de manière plus stable et que la dissipation de puissance convertie dans le redresseur soit réduite.

7. Dispositif générateur selon la revendication 6, **caractérisé en ce que** le circuit redresseur (54) comporte une borne de cathode, une borne d'anode et un circuit électronique prévu entre la borne de cathode (K) et la borne d'anode (A), qui comporte deux diodes Zener (D7, D3) montées en série entre la borne de cathode (K) et la borne d'anode (A), dont les tensions de claquage sont dépassées lors de la présence d'un délestage, de sorte qu'en résulte un passage du courant au travers des diodes Zener (D7, D3).

8. Dispositif générateur selon la revendication 7, **caractérisé en ce que** chaque passage du courant au travers des diodes Zener (D7, D3) commande un circuit à transistor (Q5, Q6), dont la sortie est connectée à l'entrée d'un amplificateur de courant (Q3, Q4), et la sortie de l'amplificateur de courant (Q3, Q4) est connectée à la borne de grille du transistor MOS.

9. Dispositif générateur selon la revendication 8, **caractérisé en ce qu'**une première des deux diodes Zener (D7) est agencée entre la borne de cathode (K) et la borne de commande du circuit à transistor.

10. Dispositif générateur selon la revendication 9, **caractérisé en ce que** la deuxième des deux diodes Zener (D3) est agencée entre la borne de commande du circuit à transistor et la borne d'anode (A).

11. Dispositif générateur selon la revendication 10, **caractérisé en ce que** la valeur de tension prédéfinie est déterminée par la tension de claquage de la première diode Zener (D7).
